# EUROPÄISCHE PATENTSCHRIFT

(11) **EP 0 472 880 B1**
(45) Veröffentlichungstag und Bekanntmachung des Hinweises auf die Patenterteilung: **16.10.1996**
(21) Anmeldenummer: 91111847.9
(22) Anmeldetag: 16.07.1991
(51) Int. Cl.: H01L 29/74, H01L 29/10, H01L 29/36, H01L 21/332

(54) **Verfahren zur Herstellung eines Thyristors mit definiertem Lateral-Widerstand**
Method of making a thyristor having a well defined lateral resistance
Procédé de fabrication d'un thyristor ayant une résistance latérale déterminée

(30) Priorität: 20.08.1990 DE 4026318
(43) Veröffentlichungstag der Anmeldung: 04.03.1992
(73) Patentinhaber: SIEMENS AKTIENGESELLSCHAFT, 80333 München (DE)
(72) Erfinder: Kuhnert, Reinhold, Dr., W-8000 München 19 (DE); Mitlehner, Heinz, Dr., W-8000 München 40 (DE); Schulze, Hans-Joachim, Dr., W-8012 Ottobrunn (DE); Pfirsch, Frank, Dr., W-8000 München 90 (DE)

(56) Entgegenhaltungen:
- EP-A- 0 039 509
- EP-A- 0 176 778
- EP-A- 0 262 356
- WO-A-86/00469
- INTERNATIONAL ELECTRON DEVICES MEETING, HELD IN WASHINGTON, D.C., TECHNICALDIGEST. Dezember 1981, NEW YORK US Seiten 406 - 409; V. A. K. TEMPLE:'Controlled thyristor turn-on for high di/dt capability'

## Beschreibung

Die Erfindung bezieht sich auf ein Verfahren zur Herstellung eines Thyristors mit definiertem Lateral-Widerstand nach dem Oberbegriff des Patentanspruchs 1.

Aus den Konferenzunterlagen zur "IEEE International Conference Thyristors And Variable And Static Equipment For AC und DC Transmission", 30.11.1981 bis 03.12.1981 in London, aus der darin enthaltenen Veröffentlichung von V. A. K. Temple (GE) zum Thema "Advanced Light Triggered Thyristors For Electric Power Systems", insbesondere Seite 90, Figur 7 und Seite 91, Figur 10 sind ein Thyristor und ein Verfahren dieser Art bekannt. Bei dem von V. A. K. Temple beschriebenen Thyristor mit Amplifying-Gate-Struktur wird ein definierter Lateral-Widerstand dadurch erzeugt, daß erst eine p-Basis durch Diffusion gebildet wird und dann am Ort des zu realisierenden Widerstandes die p-Basis dünner geätzt wird.

Ferner ist aus der internationalen Anmeldeschrift mit der Veröffentlichungsnummer WO 86/00469 ein Thyristor mit einem Lateral-Widerstand zwischen einer Gate-Stufe und einer Hauptstufe bekannt, wobei dieser Laterail-Widerstand beispielsweise auch durch eine Ionenimplantation mit einer geringen Dotierungskonzentration erzeugt wird.

Aus der IEEE-Veröffentlichung zur IEDM Dez. 81, Seiten 406 bis 409 ist weiter bekannt, daß dieser Lateral-Widerstand auch zwischen einer Spannungs-Sollbruchstelle und einer Gate-Stufe vorgesehen werden kann.

Weitere Verfahren sind in den Dokumenten EP-A-262356 und EP-A-176778 beschrieben.

Der Erfindung liegt die Aufgabe zugrunde, ein Verfahren zur Herstellung eines Thyristors der eingangs genannten Art anzugeben, dessen Lateral-Widerstand einen gut reproduzierbaren Widerstandswert besitzt und der mit minimalem prozeßtechnischen Aufwand integrierbar ist. Die Aufgabe wird erfindungsgemäß durch die im kennzeichnenden Teil des Patentanspruchs 1 angegebenen Merkmale gelöst.

Der mit der Erfindung erzielbare Vorteil liegt insbesondere darin, daß die Widerstandswerte des Lateral-Widerstandes besser als bei dem eingangs zitierten Verfahren eingestellt werden können.

Die Patentansprüche 2 bis 7 sind auf bevorzugte Verfahren zur Herstellung eines erfindungsgemäßen Thyristors gerichtet.

Die Erfindung wird nachfolgend anhand der Zeichnung näher erläutert. Dabei zeigt
- Figur 1: eine zweiteilige Darstellung zur Erläuterung der Herstellung eines erfindungsgemäßen Thyristors, bei dem eine Belegungsstruktur mit Hilfe von Diffusion und Ätzung erzeugt wird,
- Figur 2: eine zweiteilige Darstellung zur Erläuterung der Herstellung eines erfindungsgemäßen Thyristors, bei dem eine Belegungsstruktur durch maskierte Implantation erzeugt wird,
- Figur 3: eine Schnittdarstellung eines erfindungsgemäßen Thyristors mit Amplifying-Gate-Struktur und
- Figur 4: ein Ersatzschaltbild des Thyristors nach Figur 3.

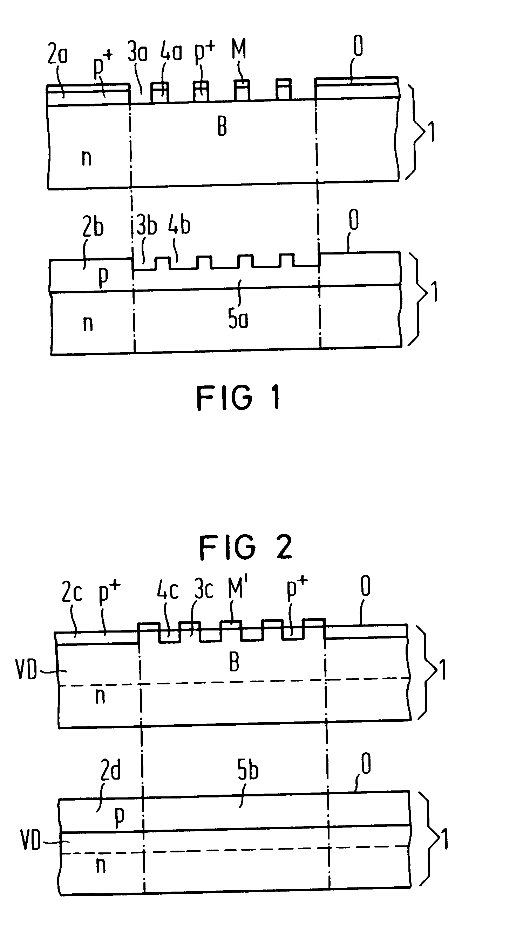

Die zweiteilige Darstellung von Figur 1 zeigt sowohl im oberen als auch im unteren Teil einen oberflächennahen Bereich eines erfindungsgemäßen Thyristors in den ein Lateral-Widerstand integriert wird. Der obere Teil der Darstellung stellt dabei den Bereich des Thyristors zu einem frühen Zeitpunkt des Herstellverfahrens dar, der untere Teil der Darstellung hingegen stellt den selben Bereich des Thyristors am Ende des Herstellverfahrens dar. Der obere Teil der Darstellung zeigt einen n-dotierten Halbleiterkörper 1, zum Beispiel aus Silizium, in den eine p⁺-dotierte Belegungsschicht 2a eingebracht ist, deren Oberfläche O durch eine Ätzmaske M abgedeckt ist. Die Ätzmaske M und die darunterliegende Belegungsschicht 2a besitzen in einem Strukturierungsbereich B mehrere regelmäßig angeordnete Aussparungen 3a, die jeweils durch Stege 4a voneinander getrennt sind. Der untere Teil der Darstellung zeigt den n-dotierten Halbleiterkörper 1 in den eine p-dotierte Schicht 2b eingebracht ist, die dicker ist als die Belegungsschicht 2a aber eine geringere Dotierungskonzentration als diese besitzt.

An der Oberfläche O befindliche Aussparungen 3b und Stege 4b haben die gleiche Form wie im oberen Teil der Darstellung. Im oberen Teil der Darstellung besitzen die Stege 4a die gleiche Dotierungskonzentration wie die Belegungsschicht 2a außerhalb des Strukturierungsbereiches B, im unteren Teil der Darstellung hingegen besitzen die Stege 4b und der gesamte Widerstandsbereich 5a eine geringere Dotierungskonzentration als die Schicht 2b außerhalb des Strukturierungsbereiches B.

In den n-dotierten Halbleiterkörper 1 wird, von der Oberfläche O her, ganzflächig eine p⁺-dotierte Belegungsschicht 2a eindiffundiert. Ist dies erfolgt, so wird die Oberfläche O mit einer Ätzmaske M abgedeckt, die im Strukturierungsbereich B regelmäßig angeordnete Maskenöffnungen aufweist. Durch nachfolgendes Ätzen werden unterhalb der Maskenöffnungen in der Belegungsschicht 2a Aussparungen 3a gebildet, die mindestens so tief sind wie die Dicke der Belegungsschicht 2a. Würde die Belegungsschicht 2a nicht vollständig durchgeätzt, so würde der Wert des Lateral-Widerstandes aufgrund eines sehr steilen Dotierungsprofiles und einer relativ ungenau bestimmbaren Ätztiefe weiterhin von Thyristor zu Thyristor stark variieren. Nach dem Entfernen der Ätzmaske M werden, durch Aufheizen von der Oberfläche O her, die Dotierungsatome der p⁺-dotierten Belegungsschicht in den n-dotierten Halbleiterkörper 1 eingetrieben. Die Dotierungskonzentration der ursprünglichen Belegungsschicht 2a nimmt dadurch ab und die Belegungsschicht dehnt sich in vertikaler Richtung aus, wodurch die zur Belegungsschicht 2a relativ dicke p-dotierte Schicht 2b erzeugt wird. Im Strukturierungsbereich B bilden die Stege 4a, zweidimensional betrachtet, punktförmige Dotierungsquellen für das Widerstandsgebiet 5a. Die Dotierungskonzentration kann hierbei sehr gut durch das Verhältnis zwischen Aussparungsbreite zu Stegbreite definiert eingestellt werden. Durch das Eintreiben der Dotierungsatome stellt sich innerhalb des Widerstandsbereiches 5a eine in weiten Teilen homogene Dotierungskonzentration und somit ein gut reproduzierbarer Widerstandswert des Lateral-Widerstandes ein.

Ähnlich wie Figur 1, zeigt Figur 2 jeweils zu einem frühen Verfahrenszeitpunkt und am Ende des Verfahrens einen oberflächennahen Bereich eines erfindungsgemäßen Thyristors in den ein Lateral-Widerstand integriert wird. Ein oberer Teil von Figur 2 zeigt hierbei einen n-dotierten Halbleiterkörper 1, in den eine dünne, p⁺-dotierte Belegungsschicht 2c eingebracht ist. Aussparungen 3c liegen unter undurchlässigen Teilen einer Implantationsmaske M', die sich selbst unmittelbar auf der Oberfläche O der Belegungsschicht 2c befindet, und bestehen aus dem n-dotierten Halbleiterkörper 1. Die verbleibenden Stege 4c zwischen den Aussparungen 3c sind gleich dick wie die Belegungsschicht 2c und sind ebenfalls p⁺-dotiert. Der untere Teil von Figur 2 zeigt einen n-dotierten Halbleiterkörper 1 in den eine dicke, p-dotierte Schicht 2d von einer Oberfläche 0 her eingebracht ist. Im Strukturierungsbereich B befindet sich ein Widerstandsbereich 5b, der ungefähr dieselbe Schichtdicke wie die Schicht 2d aufweist aber eine niedrigere Dotierungskonzentration als diese besitzt. Die Oberfläche O ist im Strukturierungsbereich B im Gegensatz zu Figur 1 völlig eben, da in diesem Fall keine Ätzung erfolgt.

Der n-dotierte Halbleiterkörper 1 wird an seiner Oberfläche 2 mit einer Implantationsmaske M' so belegt, daß die Aussparungen 3c im Strukturierungsbereich B abgedeckt sind. Jetzt wird eine p⁺-dotierte Belegungsschicht 2c von der Oberfläche 0 her implantiert und es entstehen im Strukturierungsbereich B p⁺-dotierte Stege 4c zwischen den weiterhin n-dotierten Aus-sparungen 3c unterhalb der undurchlässigen Teile der Implantationsmaske M'. Nach dem Entfernen der Implantationsmaske M' folgt, wie bereits bei Figur 1 erläutert, ein Eintreibeschritt. Aufgrund eines Temperaturgradienten wird hierbei eine zur Belegungsschicht relativ dicke Schicht 2c mit p-Dotierung erzeugt, die im Strukturierungsbereich B infolge geringerer Dotierungskonzentration den Widerstandsbereich 5b bildet.

Zur Erhöhung der Sperrfähigkeit kann anstelle des einheitlich p-dotierten Halbleiterkörpers 1 von einem, z. B. mit Aluminium, vordotierten Halbleiterkörper 1 ausgegangen werden. Ein Bereich VD des Halbleiterkörpers 1 ist von der Oberfläche O her schwach p-dotiert und die sich zum n-dotierten Halbleiterkörper ergebende Dotierungsgrenzfläche ist in beiden Teilen von Figur 2 gestrichelt dargestellt.

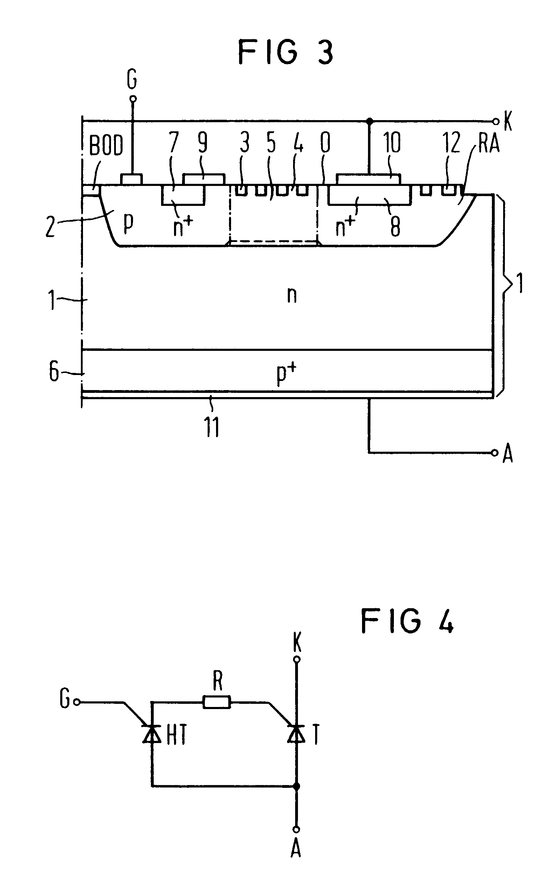

Figur 3 zeigt eine Schnittdarstellung eines erfindungsgemäßen Thyristors mit Amplifying-Gate-Struktur, bei dem ein Widerstandsbereich 5 zwischen einer Hilfsemitterelektrode 9 und einer Kathodenelektrode 10 in einer durch Diffusion erzeugten p-Basisschicht 2 gebildet wurde. Im Widerstandsbereich 5 besitzt die Dotierungsgrenzlinie (Linie gleicher Dotierungskonzentration) zwischen p-Schicht 2 und dem n-dotierten Teil des Halbleiterkörpers 1 eine gestrichelt dargestellte Einbuchtung, die aus der geringeren Dotierungskonzentration in diesem Bereich resultiert. Der Thyristor besteht wie üblich aus vier Schichten, aus einer p⁺-Emitterschicht 6, die mit der Anodenelektrode 11 kontaktiert ist, einer n-Basis aus einem Halbleitergrundkörper 1, einer p-Basisschicht 2, die durch Eintreiben einer p⁺-Belegungsschicht entstanden ist, und zwei n⁺-Emitter 7 und 8, die von einer Oberfläche O aus in die p-Basisschicht 2 eingebracht sind. Zwischen der Thyristormitte und dem Hilfsemitter 7 ist eine Gateelektrode G an der Oberfläche O mit der p-Basisschicht 2 kontaktiert. Der Hilfsemitter 7 ist von der Hilfsemitterelektrode 9 so überdeckt, daß eine elektrische Verbindung mit der p-Basisschicht 2 zwischen dem n⁺-Emitter 7 und dem Widerstandsbereich 5 entsteht. Der Emitter 8 ist mit der Kathodenelektrode 10, die Kathodenelektrode 10 ist mit einem Kathodenanschluß K und die Anodenelektrode 11 ist mit einem Anodenanschluß A verbunden. In einem zentralen Bereich der Oberfläche O ist eine Spannungssollbruchstelle BOD in Form einer Ätzmulde und in einem Randbereich der Oberfläche O sind ringförmige Aussparungen 12 zur Erzeugung einer Randstruktur RA vorgesehen. Herausgeätzte Aussparungen 3 und dadurch gebildete Stege 4 zur Erzeugung des Widerstandsbereiches 5 sind vorteilhafterweise zusammen mit der Spannungssollbruchstelle BOD und dem Randabschluß RA herstellbar. Werden die Aussparungen 3 durch maskierte Implantation erzeugt, so kann dies ebenfalls gemeinsam mit den ringförmigen Aussparungen 12 zur Erzeugung der Randstruktur RA und der Aussparung zur Erzeugung einer Spannungssollbruchstelle BOD geschehen.

Das Ersatzschaltbild von Figur 4 beschreibt den Thyristor mit Amplifying-Gate-Struktur aus Figur 3 und zeigt einen Hauptthyristor T zwischen einer Kathode K und einer Anode A, dessen Gate über einen Widerstand R mit der Kathode eines Hilfsthyristors HT verbunden ist, dessen Anode mit der Anode A des Hauptthyristors verbunden ist.

Erhält das Gate G eine positive Spannung gegenüber der Kathode K so zündet der Hilfsthyristor HT und über den Widerstand R danach auch der Hauptthyristor T. Oftmals werden auch mehrstufige Amplifying-Gate-Stufen eingesetzt, die in jeder einzelnen Stufe, also auch zwischen Hilfsemittern, einen entsprechenden Widerstand besitzen. Selbst zwischen der Spannungs-sollbruchstelle BOD und der Gateelektrode G oder der Gateelektrode G und dem Hilfsemitter 7 sind integrierte Lateral-Widerstände denkbar. In Thyristoren mit Amplifying-Gate-Struktur bewegen sich die benötigten Widerstandswerte in der Größenordnung von einigen zehn Ohm. Die Widerstände dienen als Schutzwiderstände und bewirken, daß der Stromanstieg im primären Zündbereich (Thyristormitte) begrenzt wird und höhere Stromstärken dadurch erst bei der Zündung nachfolgender Amplifying-Gate-Stufen (im Hauptkathodenbereich) auftreten.

Das Verfahren zur Herstellung eines definierten Lateral-Widerstandes ist für optisch zündbare Thyristoren, sowie für Thyristoren mit integriertem Überspannungsschutz (BOD-Struktur) von besonderer Bedeutung.

## Patentansprüche

1. Verfahren zur Herstellung eines Thyristors mit integriertem Lateral-Widerstand (R), bei dem der Lateral-Widerstand aus einem Widerstandsbereich besteht, der sich in einem von einer Oberfläche des Thyristors zugänglichen Bereich einer p-BasisSchicht befindet, bei dem der Widerstandbereich (5) eine definiert geringere Dotierungskonzentration als die ihn umgebende p-Basis-Schicht (2) besitzt und bei dem sich der Lateral-Widerstand (R) zwischen einer Spannungssollbruchstelle (BOD) und einer Gateelektrode (G) und/oder zwischen einer Gateelektrode und einem Hilfsemitter und/oder zwischen dem Hilfsemitter und einem weiteren Hilfsemitter und/oder zwischen einem Hilfsemitter (7) und einem Emitter (8) befindet,
**dadurch gekennzeichnet,**
daß in einem Halbleiterkörper (1) eines ersten Leitungstyps (n) eine dünne Belegungsschicht (2a, 2c) des zweiten Leitungstyps mit hoher Dotierungskonzentration (p⁺) von einer Oberfläche (0) her erzeugt wird, daß innerhalb eines Strukturierungsbereiches (B) in die Belegungsschicht regelmäßig angeordnete Aussparungen (3) eingebracht werden und jeweils Stege (4a, 4c) zwischen den Aussparungen (3a, 3c) bestehen bleiben, daß der Widerstandswert des Lateral-Widerstandes (R) durch das Breitenverhältnis der Aussparungen zu den Stegen definiert und in engen Grenzen eingestellt wird, daß durch Erhitzen des Halbleiter-körpers (1) die dünne Belegungsschicht (2a, 2c) des zweiten Leitungstyps mit hoher Dotierungskonzentration (p⁺) in den Halbleiterkörper (1) eingetrieben wird, daß dabei aus der dünnen Belegungsschicht mit hoher Dotierungskonzentration eine dicke Schicht (2b, 2d) des zweiten Leitungstyps mit geringerer Dotierungskonzentration (p) gebildet wird, daß im Strukturierungsbereich (B), infolge der Aussparungen (3a, 3c), eine definiert geringere Dotierungskonzentration erzeugt wird als in der dicken Schicht (2b, 2d) außerhalb des Strukturierungsbereiches (B) und daß durch die definiert geringere Dotierungskonzentration im Strukturierungsbereich (B) der Lateral-Widerstand (R) mit in engen Grenzen definiertem Widerstandswert gebildet wird.

2. Verfahren nach Anspruch 1, **dadurch gekennzeichnet,** daß die dünne Belegungsschicht (2a) des zweiten Leitungstyps mit hoher Dotierungskonzentration (p⁺) durch Diffusion in den Halbleiterkörper (1) des ersten Leitungstyps (n) erzeugt wird und daß im Strukturierungsbereich (B) regelmäßig angeordnete Aussparungen (3a) mit Hilfe einer Ätzmaske (M) aus der Belegungsschicht (2a) herausgeätzt werden.

3. Verfahren nach Anspruch 2, **dadurch gekennzeichnet,** daß die Diffusion mit Aluminium erfolgt.

4. Verfahren nach Anspruch 1, **dadurch gekennzeichnet**, daß die dünne Belegungsschicht (2c) des zweiten Leitungstyps mit hoher Dotierungskonzentration (p⁺) durch Implantation in den Halbleiterkörper (1) des ersten Leitungstyps (n) erzeugt wird und daß die Aussparungen (3c) und Stege (4c) innerhalb des Strukturierungsbereiches (B) durch Verwendung einer Implantationsmaske (M') erzeugt werden, wobei die Aussparungen (3c) jeweils unterhalb von undurchlässigen Bereichen der Implantationsmaske (M') liegen.

5. Verfahren nach Anspruch 4, **dadurch gekennzeichnet,** daß die Implantation mit Bor erfolgt.

6. Verfahren nach Anspruch 1, **dadurch gekennzeichnet**, daß die Aussparungen (3a, 3c) zur Bildung des Lateral-Widerstandes (R) gleichzeitig mit Bereichen zur Bildung von Spannungssollbruchstelle und/oder Randabschluß erzeugt werden.

7. Verfahren nach Anspruch 4, **dadurch gekennzeichnet,** daß vor der Erzeugung der Belegungsschicht (2c) ganzflächig eine Vordotierungschicht (VD) des zweiten Leitungstyps (p) in den Halbleiterkörper (1) von der Oberfläche (O) her eingebracht wird.

## Claims

1. Method for the production of a thyristor having an integrated lateral resistor (R), in which the lateral resistor consists of a resistor region situated in a region of a p-type base layer which is accessible from a surface of the thyristor, in which the resistor region (5) has a defined lower doping concentration than the p-type base layer (2) surrounding it, and in which the lateral resistor (R) is situated between a desired voltage breakover point (BOD) and a gate electrode (G) and/or between a gate electrode and an auxiliary emitter and/or between the auxiliary emitter and a further auxiliary emitter and/or between an auxiliary emitter (7) and an emitter (8), characterized in that a thin deposition layer (2a, 2c) of the second conduction type and having a high doping concentration (p⁺) is produced in a semiconductor body (1) of a first conduction type (n), starting from a surface (O), in that, within a structuring region (B), regularly arranged recesses (3) are introduced into the deposition layer and respective webs (4a, 4c) are left between the recesses (3a, 3c), in that the resistance value of the lateral resistor (R) is defined by the width ratio between the recesses and the webs and is set within narrow limits, in that the thin deposition layer (2a, 2c) of the second conduction type and having a high doping concentration (p⁺) is driven into the semiconductor body (1) by heating the semiconductor body (1), in that a thick layer (2b, 2d) of the second conduction type and having a lower doping concentration (p) is formed in the process from the thin deposition layer having a high doping concentration, in that a defined lower doping concentration is produced in the structuring region (B), on account of the recesses (3a, 3c), than in the thick layer (2b, 2d) outside the structuring region (B), and in that the lateral resistor (R) having a resistance value which is defined within narrow limits is formed as a result of the defined lower doping concentration in the structuring region (B).

2. Method according to Claim 1, characterized in that the thin deposition layer (2a) of the second conduction type and having a high doping concentration (p⁺) is produced by diffusion into the semiconductor body (1) of the first conduction type (n), and in that, in the structuring region (B), regularly arranged recesses (3a) are etched out of the deposition layer (2a) with the aid of an etching mask (M).

3. Method according to Claim 2, characterized in that the diffusion is carried out using aluminium.

4. Method according to Claim 1, characterized in that the thin deposition layer (2c) of the second conduction type and having a high doping concentration (p⁺) is produced by implantation into the semiconductor body (1) of the first conduction type (n), and in that the recesses (3c) and webs (4c) within the structuring region (B) are produced by using an implantation mask (M'), the recesses (3c) in each case lying below impervious regions of the implantation mask (M').

5. Method according to Claim 4, characterized in that the implantation is carried out using boron.

6. Method according to Claim 1, characterized in that the recesses (3a, 3c) for forming the lateral resistor (R) are produced at the same time as regions for forming a desired voltage breakover point and/or an edge termination.

7. Method according to Claim 4, characterized in that, before the deposition layer (2c) is produced, a predoping layer (VD) of the second conduction type (p) is introduced into the semiconductor body (1) over the whole area, starting from the surface (O).

## Revendications

1. Procédé de fabrication d'un thyristor à résistance (R) latérale intégrée, dans lequel la résistance latérale consiste en une zone de résistance, qui se trouve dans une zone, accessible d'une surface du thyristor, d'une couche de base p, dans lequel la zone (5) de résistance a une concentration de dopant inférieure, d'une valeur définie, à celle de la couche (2) de base p l'entourant et dans lequel la résistance (R) latérale se trouve entre un point (BOD) de rupture de tension et une électrode (G) de grille et/ou entre une électrode de grille et un émetteur auxiliaire et/ou entre l'émetteur auxiliaire et un autre émetteur auxiliaire et/ou entre un émetteur auxiliaire (7) et un émetteur (8),
caractérisé en ce que
on produit à partir d'une surface (0), dans un corps (1) semiconducteur d'un premier type (n) de conductivité une couche mince (2a, 2c) d'occupation du second type de conductivité et à concentration (p⁺) de dopant grande, on ménage à l'intérieur d'une zone (B) de structuration des évidements (3) disposés régulièrement dans la couche d'occupation, des barrettes (4a, 4c) subsistant entre les évidements (3a, 3c), on définit la valeur de la résistance (R) latérale par le rapport de largeur des évidements à celle des barrettes et on la règle dans des limites étroites, on enfonce, par chauffage du corps (1) semiconducteur la couche (2a, 2c) mince d'occupation du second type de conductivité et à grande concentration (p⁺) de dopant dans le corps (1) semiconducteur, on y forme, à partir de la couche mince d'occupation à grande concentration de dopant une couche épaisse (2b, 2d) du second type de conductivité et à concentration (p) de dopant plus petite, on produit dans la zone (B) de structuration, par suite des évidements (3a, 3c) une concentration de dopant inférieure, d'une valeur définie, à celle de la couche épaisse (2b, 2d) en dehors de la zone (B) de structuration et on forme, par la concentration de dopant plus petite, d'une valeur définie, dans la zone (B) de structuration, la résistance (R) latérale ayant une valeur de résistance définie dans des limites étroites.

2. Procédé suivant la revendication 1,
caractérisé en ce que l'on produit la couche mince (2a) d'occupation du second type de conductivité et à concentration (p⁺) de dopant grande par diffusion dans le corps (1) semiconducteur du premier type (n) de conductivité et on forme, par attaque chimique de la couche (2a) d'occupation et à l'aide d'un masque (M) d'attaque chimique des évidements (3a) disposés régulièrement dans la zone (B) de structuration.

3. Procédé suivant la revendication 2,
caractérisé en ce que l'on effectue la diffusion avec de l'aluminium.

4. Procédé suivant la revendication 1,
caractérisé en ce que l'on produit la couche mince (2c) d'occupation du second type de conductivité et à concentration (p⁺) de dopant grande par implantation au corps (1) semiconducteur du premier type (n) de conductivité et on produit les évidements (3c) et les barrettes (4c) à l'intérieur de la zone (B) de structuration en utilisant un masque (M') d'implantation, les évidements (3c) étant chacun en-dessous de zones du masque (M') d'implantation opaques au rayonnement.

5. Procédé suivant la revendication 4,
caractérisé en ce que l'on effectue l'implantation avec du bore.

6. Procédé suivant la revendication 1,
caractérisé en ce que l'on produit les évidements (3a, 3c) pour la formation de la résistance latérale (R) en même temps que des zones pour la formation de points de rupture de tension et/ou de terminaison de bord.

7. Procédé suivant la revendication 4,
caractérisé en ce que l'on met en place, avant de produire la couche (2c) d'occupation, sur toute la surface une couche (VD) de dopage préalable du second type (p) de conductivité dans le corps (1) semiconducteur à partir de la surface (0).
